(19) Europäisches Patentamt / European Patent Office / Office européen des brevets

(11) **EP 2 559 972 B1**

(12) **FASCICULE DE BREVET EUROPEEN**

(45) Date de publication et mention de la délivrance du brevet:
**21.09.2016 Bulletin 2016/38**

(51) Int Cl.:
***G01D 5/48*** *(2006.01)*

(21) Numéro de dépôt: **12180015.5**

(22) Date de dépôt: **10.08.2012**

(54) **Procédé d'interrogation d'un capteur différentiel de type acoustique à deux résonances et dispositif mettant en ?uvre le procédé d'interrogation**

Abfrageverfahren eines differentiellen Akustiksensors mit zwei Resonanzen, und Vorrichtung zur Umsetzung dieses Abfrageverfahrens

Method for querying an acoustic differential sensor with two resonances and device implementing the querying method

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.08.2011 FR 1157379**

(43) Date de publication de la demande:
**20.02.2013 Bulletin 2013/08**

(73) Titulaire: **Senseor**
**06250 Mougins (FR)**

(72) Inventeurs:
• **Droit, Christophe**
**25000 BESANCON (FR)**
• **Friedt, Jean-Michel**
**25000 BESANCON (FR)**
• **Martin, Gilles**
**25870 CHATILLON LE DUC (FR)**
• **Ballandras, Sylvain**
**25000 BESANCON (FR)**

(74) Mandataire: **Esselin, Sophie**
**Marks & Clerk France**
**Conseils en Propriété Industrielle**
**Immeuble Visium**
**22 Avenue Aristide Briand**
**94117 Arcueil Cedex (FR)**

(56) Documents cités:
**US-A1- 2009 001 850**

• **FRIEDT J-M ET AL: "A wireless interrogation system exploiting narrowband acoustic resonator for remote physical quantity measurement", REVIEW OF SCIENTIFIC INSTRUMENTS, AIP, MELVILLE, NY, US, vol. 81, no. 1, 11 janvier 2010 (2010-01-11), pages 14701-14701, XP012134609, ISSN: 0034-6748, DOI: 10.1063/1.3267311**
• **POHL A: "A review of wireless SAW sensors", IEEE TRANSACTIONS ON ULTRASONICS, FERROELECTRICS AND FREQUENCY CONTROL, IEEE, US, vol. 47, no. 2, 1 mars 2000 (2000-03-01), pages 317-332, XP011264630, ISSN: 0885-3010, DOI: 10.1109/58.827416**

**Description**

La présente invention concerne un procédé d'interrogation d'un capteur différentiel présentant au moins deux résonances ayant une sensibilité propre à un ou plusieurs phénomènes à caractériser. La présente invention concerne également un dispositif mettant en oeuvre un tel procédé. Elle s'applique notamment à des capteurs différentiels passifs formés par une paire de résonateurs. Ces résonateurs peuvent avantageusement être de type acoustique à ondes de surface ou de volume.

Un capteur différentiel peut être formé par une paire de résonateurs, chacun des résonateurs pouvant être réalisé par le dépôt de microstructures sur la surface d'un substrat piézoélectrique. De tels résonateurs appartiennent à la famille des composants de type acoustique à ondes de surface, communément désignés composants "SAW", suivant l'acronyme correspondant à la terminologie anglaise "Surface Acoustic Wave", ou à ondes de volume, communément désignés suivant l'acronyme "BAW" correspondant à la terminologie anglaise "Bulk Acoustic Wave".

La présente invention concerne des capteurs différentiels sensibles à différents paramètres physiques, par exemple la température ou la pression. Les résonateurs SAW et BAW présentent l'avantage de pouvoir être interrogés à distance, mais également de ne pas requérir une alimentation en énergie. Pour la suite, il sera fait référence à l'interrogation d'un capteur SAW ou BAW, pour désigner le recueil des informations relatives à la mesure d'un paramètre physique.

D'une manière typique, les capteurs SAW, par exemple, peuvent être réalisés par le dépôt de motifs métalliques sur le substrat piézoélectrique, le matériau piézoélectrique pouvant par exemple être constitué de quartz ($SiO_2$), de niobate de lithium ($LiNbO_3$) ou de tantalate de lithium ($LiTaO_3$). Un résonateur peut par exemple être constitué de transducteurs interdigitaux, autour desquels sont répartis des réflecteurs et des électrodes. Des signaux électromagnétiques radiofréquence peuvent entraîner la génération d'une onde acoustique de surface, par exemple une onde de Rayleigh, par les transducteurs, l'onde acoustique se propage alors au sein du réseau d'électrodes et de réflecteurs, et les transducteurs réémettent un signal radiofréquence qui peut être capté par une antenne, et analysé par des moyens appropriés. Par construction, un résonateur offre une fréquence propre de résonance, dépendant notamment de la configuration physique du résonateur et du choix des matériaux qui le constituent. La fréquence propre de résonance d'un résonateur est également dépendante des paramètres physiques environnants, tels que la température ou la pression. Une structure différentielle permet par exemple de réaliser la mesure d'un paramètre spécifique, en s'affranchissant de l'influence simultanée d'autres paramètres physiques. Une telle structure permet en outre un étalonnage aisé du capteur. Dans une structure différentielle, un des deux résonateurs est communément désigné résonateur de référence, l'autre résonateur étant désigné résonateur de mesure.

La mesure du paramètre physique considéré s'effectue par une appréciation de la différence entre les fréquences propres de résonance des deux résonateurs formant le capteur différentiel. Dès lors, il est préférable que les résonateurs formant le capteur différentiel soient configurés de sorte que leurs fréquences de résonance respectives se situent dans des bandes de fréquences distinctes, et que la différence des deux fréquences de résonance définisse une fonction bijective du paramètre physique mesuré, de manière à ce qu'une relation biunivoque permette la réalisation de la mesure.

L'interrogation d'un capteur différentiel est le procédé par lequel un dispositif d'interrogation émet un signal radiofréquence approprié à destination du capteur, le signal radiofréquence étant alors perçu par le capteur différentiel via une antenne radiofréquence de réception, et donnant lieu à la propagation d'une onde acoustique de surface (ou onde de volume, dans le cas de dispositifs de type BAW), celle-ci étant à son tour traduite en un signal radiofréquence réémis via une antenne d'émission, cette dernière pouvant être formée par l'antenne de réception précitée, le signal radiofréquence ainsi réémis pouvant alors être recueilli et analysé par le dispositif d'interrogation. Le signal d'interrogation émis peut se présenter sous la forme d'une brève impulsion radiofréquence.

D'une manière typique, les signaux radiofréquence précités se situent dans une bande de fréquences désignée ISM, suivant le sigle désignant la terminologie anglaise "Industrial, Scientific, Medical". Une première bande ISM se situe autour de la fréquence de 434 MHz, avec une largeur de bande de 1,7 MHz. Cette bande de fréquences est particulièrement avantageuse, notamment en raison du taux de pénétration des signaux qu'elle procure, dans des milieux diélectriques au sein desquels les capteurs peuvent être utilisés. Cependant la bande passante relativement faible est notamment préjudiciable au rapport signal à bruit, et partant à la distance maximale d'interrogation. Ce phénomène est d'autant plus significatif pour des capteurs différentiels, pour lesquels les bandes de fréquences dans lesquelles sont comprises les gammes de valeurs de fréquence de résonance des résonateurs qui les constituent, doivent être distinctes, ainsi que cela est explicité précédemment. Une problématique de fond liée à l'interrogation de capteurs SAW repose ainsi sur le rapport signal à bruit procuré par le procédé d'interrogation.

Des solutions connues de l'état de la technique permettent l'interrogation de résonateurs SAW.

Selon une première technique connue, décrite dans la publication « Friedt, J.-M. ; Droit, C. ; Martin, G. ; Ballandras, S. "A wireless interrogation system exploiting narrowband acoustic resonator for remote physical quantity measurement", Rev. Sci. Instrum. Vol. 81, 014701 (2010) », l'interrogation peut être réalisée par un balayage en fréquence du signal d'interrogation d'encombrement spectral inférieur à la largeur de la résonance, autour de la fréquence propre de résonance du premier résonateur d'une part, et du deuxième résonateur d'autre part, suivi d'une analyse de la puissance du signal reçu en écho, les fréquences d'émission pour lesquelles la puissance du signal reçu est maximale déterminant alors les deux fréquences propres de résonance recherchées. Un commutateur radiofréquence peut permettre d'alterner des phases d'émission et des phases d'écoute. Cette première technique présente notamment l'inconvénient de requérir des détecteurs de puissance de large bande, ces dispositifs étant relativement complexes et coûteux.

Selon une deuxième technique connue et décrite dans la publication « Hamsch, M. ; Hoffmann, R. ; Buff, W. ; Binhack, M. ; Klett, S. ; "An interrogation unit for passive wireless SAW sensors based on Fourier transform Ultrasonics, Ferroelectrics and Frequency Control", IEEE Transactions on, Nov. 2004 », l'interrogation peut être réalisée par un balayage en fréquence d'un signal d'interrogation d'encombrement spectral plus important que la largeur de résonance du capteur, dans une gamme de fréquences couvrant les deux fréquences propres de résonance des résonateurs, suivi d'une conversion analogique-numérique du signal reçu en écho, permettant de réaliser une transformée de Fourier rapide et une extraction du spectre de ce signal, duquel peuvent être déduites les deux fréquences propres de résonance recherchées. Cette deuxième technique présente notamment l'inconvénient de requérir des moyens de calcul importants.

Un but de la présente invention est de pallier au moins les inconvénients précités, en proposant un procédé d'interrogation de capteurs différentiels offrant un bon rapport signal à bruit, une bonne précision de mesure, sans requérir des moyens de calcul complexes.

Un autre avantage de l'invention est que celle-ci peut aisément être mise en oeuvre via un dispositif de type radio-modem disponible sur le marché pour un coût raisonnable, et non dédié spécifiquement à ce type d'applications.

A cet effet, l'invention a pour objet un procédé d'interrogation d'un capteur comportant aux moins deux résonateurs dont la fréquence propre de résonance est dépendante d'un paramètre physique, le procédé étant caractérisé en ce qu'il comprend une étape d'émission d'un signal électromagnétique dont la fréquence est variée dans une bande de fréquences par pas de valeur déterminée, d'une valeur minimale prédéterminée à une valeur maximale prédéterminée, la bande de fréquences étant découpée en deux sous-bandes de fréquences, chaque sous-bande de fréquence contenant au moins les valeurs attendues respectivement de chaque fréquence propre de résonance des deux résonateurs ; une étape de recueil d'un signal reçu en écho après une durée déterminée après l'émission réalisée à l'étape d'émission, pour chaque fréquence du signal électromagnétique émis ; une étape de transposition du signal reçu en écho en basse fréquence par mélange avec un signal radiofréquence dont la fréquence égale la fréquence du signal électromagnétique émis ; une étape de filtrage permettant d'éliminer les fréquences hautes du signal mélangé à l'étape de transposition, une étape de détermination de la différence entre les fréquences propres de résonance respectives desdits deux résonateurs, à partir du maximum d'inter-corrélation des caractéristiques de niveau du signal reçu en écho pour chaque sous-bande de fréquences en fonction de la fréquence du signal électromagnétique émis.

Dans un mode de réalisation de l'invention, le maximum d'inter-corrélation peut être défini par la valeur maximale du coefficient d'inter-corrélation défini suivant la relation : $X_{corr}(t) = \sum_{k=-M}^{M} s_1(k) s_2(k-t)$, dans laquelle t désigne un écart de fréquence, $s_1$ désigne le niveau du signal reçu dans la première sous-bande de fréquences, et $s_2$ désigne le niveau du signal reçu dans la seconde bande de fréquences, M désignant un nombre de points de fréquences d'interrogation dans une sous-bande de fréquences, la seconde sous-bande de fréquences supposée contenir au moins la seconde fréquence de résonance comprenant N-M points, N étant le nombre total de points de fréquences d'interrogation.

Dans un mode de réalisation de l'invention, la sous-bande la plus étroite peut être complétée par des zéros pour les points de fréquences d'interrogation situés en dehors de la bande de mesure, de manière à ce que le nombre de points de fréquences soit identique pour les deux sous-bandes de fréquences.

Dans un mode de réalisation de l'invention, ladite différence entre les fréquences propres de résonances peut être déterminée suivant la relation : $f_2-f_1 = (t+M).\Delta f$, t désignant l'écart de fréquence pour lequel le coefficient d'inter-corrélation est maximal.

La présente invention a également pour objet un procédé d'interrogation d'un capteur comportant aux moins deux résonateurs dont la fréquence propre de résonance est dépendante d'un paramètre physique comprenant une étape d'émission d'un signal électromagnétique dont la fréquence est variée dans une bande de fréquences par pas de valeur déterminée, d'une valeur minimale prédéterminée à une valeur maximale prédéterminée ; une étape de recueil d'un signal reçu en écho après une durée déterminée après l'émission réalisée à l'étape d'émission, pour chaque fréquence du signal électromagnétique émis ; une étape de transposition du signal reçu en écho en basse fréquence par mélange avec un signal radiofréquence dont la fréquence égale la fréquence du signal électromagnétique émis ; une étape de filtrage permettant d'éliminer les fréquences hautes du signal mélangé à l'étape de transposition ; une étape de détermination de la différence entre les fréquences propres de résonance respectives desdits deux résonateurs, à partir du maximum d'auto-corrélation de la caractéristique de niveau du signal reçu en écho.

Dans un mode de réalisation de l'invention, la caractéristique de niveau du signal reçu en écho peut être formée par la caractéristique de l'amplitude de la composante en phase dudit signal reçu.

Dans un mode de réalisation de l'invention, la caractéristique de niveau du signal reçu en écho peut être formée par la caractéristique de l'amplitude de la composante de quadrature dudit signal reçu.

Dans un mode de réalisation de l'invention, le procédé d'interrogation peut comprendre une étape d'ajustement ramenant la ligne de base des caractéristiques de niveau du signal reçu en écho à une valeur constante.

Dans un mode de réalisation de l'invention, ladite valeur constante peut être nulle.

La présente invention a également pour objet un dispositif d'interrogation caractérisé en ce qu'il met en oeuvre un procédé d'interrogation selon l'une quelconque des revendications précédentes, le dispositif d'interrogation comprenant au moins un commutateur radiofréquence, un générateur de signaux radiofréquence contrôlé par le commutateur radiofréquence et émettant les signaux d'interrogation à ladite fréquence variable, une antenne d'émission, une antenne de réception recevant les signaux en écho, un module d'amplification amplifiant les signaux reçus par l'antenne de réception, un mélangeur mélangeant le signal reçu en écho amplifié et un signal périodique à ladite fréquence variable, un filtre passe-bas relié à une sortie du mélangeur, des moyens de stockage stockant le niveau du signal mélangé et filtré, des moyens de calcul et d'analyse déterminant ledit maximum d'inter-corrélation ou d'auto-corrélation.

Dans un mode de réalisation de l'invention, le dispositif d'interrogation peut être formé par un dispositif de type radio-modem.
t.

Les modes de réalisation de l'invention présentés ci-après s'appliquent à des capteurs différentiels de type SAW ou BAW.

D'autres caractéristiques et avantages de l'invention apparaîtront à la lecture de la description, donnée à titre d'exemple, faite en regard des dessins annexés qui représentent :

- la figure 1, des courbes illustrant la réponse impulsionnelle d'un capteur SAW ou BAW différentiel en fonction de la fréquence d'une impulsion radiofréquence émise ;
- la figure 2, des courbes illustrant la réponse spectrale d'un capteur SAW différentiel en fonction de la fréquence d'une impulsion radiofréquence émise, et les courbes en résultant après un traitement approprié ;
- la figure 3, un logigramme illustrant un procédé d'interrogation d'un capteur SAW ou BAW différentiel, selon un mode de réalisation de l'invention ;
- la figure 4, un logigramme illustrant un procédé d'interrogation d'un capteur SAW ou BAW différentiel, selon un exemple de réalisation de l'invention ;
- la figure 5, un schéma illustrant de manière synoptique, un dispositif d'interrogation d'un capteur SAW ou BAW différentiel, dans un exemple de réalisation de l'invention ;
- la figure 6, un schéma illustrant de manière synoptique, un dispositif d'interrogation d'un capteur SAW ou BAW différentiel, formé par un radio-modem.

Par un balayage par un pas de fréquence $\Delta f$ de la fréquence f d'un signal radiofréquence impulsionnel d'interrogation, il est possible d'exciter un résonateur, l'encombrement spectral de l'impulsion radiofréquence émise étant par exemple inférieur à la largeur à mi-hauteur du résonateur, centrée sur la fréquence du signal d'interrogation f. La fraction d'énergie de l'impulsion émise recouvrant la fonction de transfert du résonateur excite un mode acoustique, permettant au résonateur d'accumuler de l'énergie. En fin d'émission, le résonateur envoie en écho un signal d'autant plus puissant que le recouvrement spectral est important, la puissance étant maximale lorsque la fréquence f correspondant à la fréquence propre de résonance $f_0$ du résonateur.

Selon la présente invention, il est proposé de porter le signal radiofréquence reçu en écho à une fréquence plus basse par un mélange avec un signal radiofréquence dont la fréquence est égale à la fréquence f de l'impulsion radiofréquence émise. Le mélange de fréquences génère un battement entre la fréquence f d'émission et la fréquence propre de résonance $f_0$ du résonateur, dont l'expression temporelle peut se formuler suivant la relation suivante :

$$signal = \sin((f \pm f_0)t) \qquad (1).$$

Les fréquences f et $f_0$ correspondent respectivement à des fréquences angulaires $\omega$ et $\omega_0$. Ainsi, la relation (1) ci-dessus peut également s'écrire sous la forme suivante :

$$signal = \cos((\omega + \omega_0)t) + \cos((\omega - \omega_0)t) \qquad (2).$$

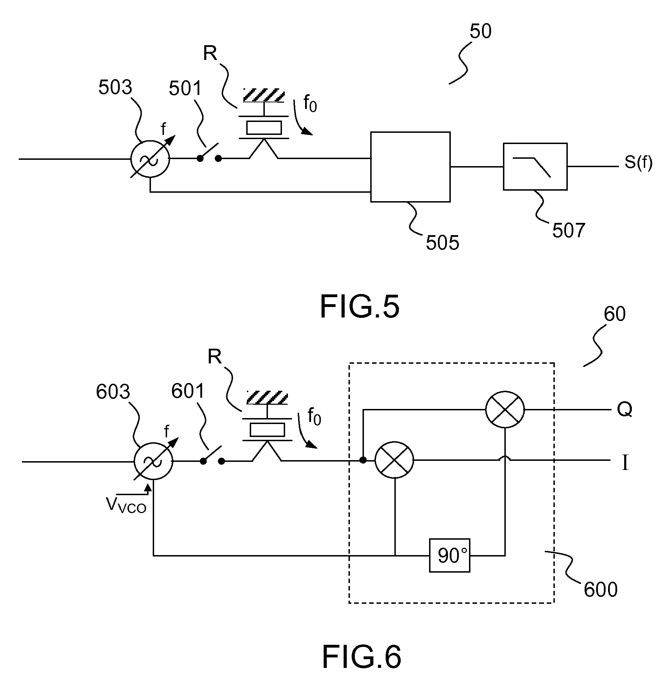

En ne conservant que la composante de basse fréquence du signal issu du mélange, c'est-à-dire le terme dans chacune des relations (1) et (2) ci-dessus ne comprenant que la composante différentielle de fréquences ou de fréquences angulaires, et en considérant un instant temporel déterminé, il est possible de représenter la caractéristique du niveau de ce signal, en terme de puissance ou d'amplitude moyenne, en fonction de la fréquence émise f. En pratique, un mélangeur peut permettre le mélange des fréquences, et le signal de sortie du mélangeur peut être filtré par un filtre passe-bas de fréquence de coupure appropriée ; l'instant temporel déterminé peut être choisi à une durée déterminée après le début ou la fin de l'impulsion radiofréquence, cette durée étant choisie de manière optimale, afin que le signal d'écho reçu soit exploitable au mieux, c'est-à-dire typiquement à une durée postérieure à un phénomène de saturation d'un étage de réception, et suffisamment précoce pour contenir un maximum d'information utile. Dans les exemples décrits ci-après, l'instant déterminé est choisi à une durée de 13 $\mu$s après le début de la fenêtre d'écoute du signal d'écho. Cette valeur n'est pas limitative de la présente invention, et correspond à une configuration expérimentale particulièrement favorable mais ne représente pas un compromis de mesure unique, et à ce titre peut être modifiée pour toute autre optimisation spécifique. Des exemples de réalisation d'un dispositif d'interrogation selon la présente invention sont décrits ci-après, en référence aux figures 5 et 6.

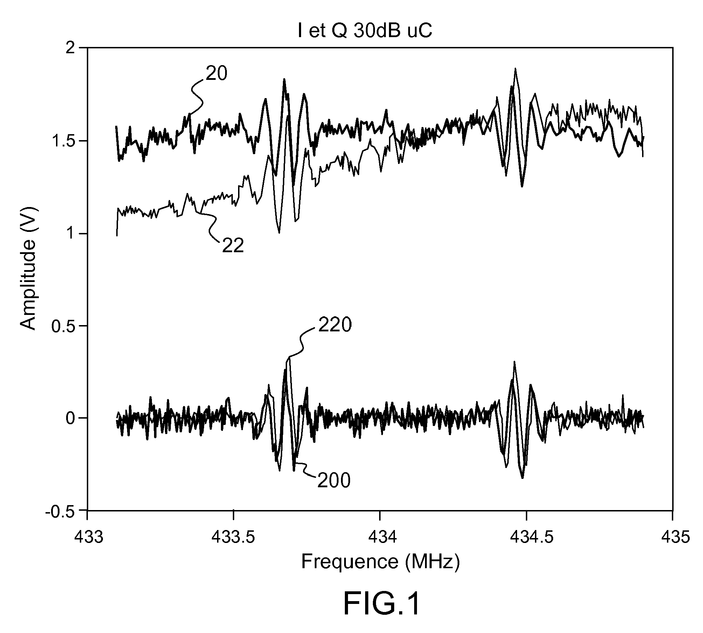

Dans le cas d'un capteur SAW différentiel tel que décrit précédemment, comportant deux résonateurs de fréquences propres de résonance respectives désignées $f_1$ et $f_2$, il est possible de varier la fréquence émise f au moins entre une première fréquence minimale $f_{1min}$ et une première fréquence maximale $f_{1max}$, puis entre une seconde fréquence minimale $f_{2min}$ et une seconde fréquence maximale $f_{2max}$, de manière à couvrir toutes les valeurs que les fréquences propres de résonance $f_1$ et $f_2$ des deux résonateurs peuvent prendre au sein du système auquel ceux-ci sont intégrés. Un exemple de la caractéristique niveau / fréquence ainsi obtenue est présenté sur la figure 1. Le paramètre physique mesuré dans les exemples décrits est la température. Bien sûr, la présente description peut être transposée à des cas où d'autres paramètres physiques sont mesurés, tels que la pression, des contraintes ou encore un couple.

La figure 1 présente une première courbe 10, en pointillés, représentant le niveau du signal mélangé et filtré précité, en fonction de la fréquence f, à une première température, par exemple la température ambiante. De la même manière, la première courbe 10 peut représenter la partie réelle (I) ou imaginaire (Q) du coefficient de réflexion du couple de résonateurs en fonction de la fréquence f. Une seconde courbe 12, en trait plein, représente le niveau du signal mélangé et filtré en fonction de la fréquence f, à une seconde température plus élevée. Dans l'exemple illustré par la figure 1, 360 échantillons ou "points" de fréquence f sont portés en abscisses, s'étalant dans la gamme de fréquences considérée, par exemple entre environ 433 MHz et 435 MHz couvrant la bande ISM centrée sur 433,9 MHz.

Les pics de niveaux maximaux sur les deux courbes 10, 12 correspondent aux deux fréquences propres de résonance $f_1$ et $f_2$. Dans l'exemple illustré par la figure 1, à température ambiante, les fréquences propres de résonance $f_1$ et $f_2$ se situent approximativement aux points 120 et 270, respectivement, correspondant aux pics maximaux de la première courbe 10. A une température plus élevée, les fréquences propres de résonance $f_1$ et $f_2$ se situent approximativement aux points 150 et 270, respectivement, correspondant aux pics maximaux de la seconde courbe 12. Dans cet exemple, le premier résonateur, dont la fréquence propre de résonance $f_1$ est inférieure à la fréquence propre de résonance $f_2$ du second résonateur, est le résonateur de mesure, c'est-à-dire celui qui est sensible au paramètre mesuré, soit la température dans l'exemple illustré. Aussi, dans cet exemple, le premier résonateur est le résonateur de référence ; également dans cet exemple, plus la température est élevée, plus la différence entre les fréquences propres de résonance $f_1$ et $f_2$ est faible. La température peut ainsi se déduire de la différence entre les deux fréquences propres de résonance $f_1$ et $f_2$, moyennant une connaissance préalable des caractéristiques fréquence de résonance / température des résonateurs.

D'un point de vue pratique, il est par exemple possible d'exploiter le niveau des composantes en phase ou de quadrature issues du signal mélangé et filtré précité. Les composantes en phase et en quadrature sont communément désignées respectivement par les lettres I et Q. Il est également possible d'exploiter le niveau d'un signal reconstruit à partir des composantes 1 et Q, par exemple le module ou le carré du module du signal mélangé et filtré, $I^2+Q^2$. La caractéristique du carré du module du signal mélangé et filtré, en fonction de la fréquence du signal d'interrogation émis n'est pas représentée sur la figure : celle-ci ne présenterait pas les oscillations apparaissant sur les courbes 10, 12. Il est enfin possible de reconstruire une grandeur complexe (parties réelle et imaginaire) d'un signal à partir de ces informations.

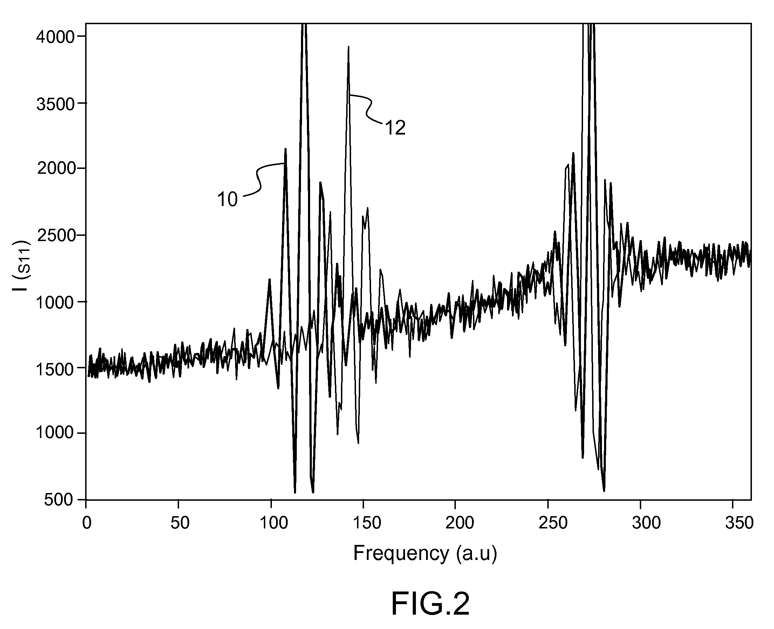

La figure 2 présente des courbes illustrant la réponse spectrale du capteur différentiel formé par les deux résonateurs, en fonction de la fréquence f de l'impulsion radiofréquence émise, et les courbes en résultant après un traitement approprié.

Sur la figure 2, une première courbe 20, en pointillés, représente le niveau de la composante en phase I du signal mélangé et filtré, en fonction de la fréquence f de l'impulsion radiofréquence émise. Une deuxième courbe 22 représente le niveau de la composante de quadrature Q du signal, en fonction de la fréquence f. La ligne de base des deux courbes 20, 22 n'est pas centrée sur une valeur constante. Egalement, les valeurs moyennes des deux courbes 20, 22 ne sont pas nécessairement égales.

Des moyens d'ajustement adéquats peuvent avantageusement permettre de ramener la ligne de base des deux courbes 20, 22 à une valeur constante, avantageusement une valeur nulle. Une troisième courbe 200 et une quatrième courbe 220 correspondent respectivement aux première et deuxième courbes 20, 22 ramenées à une ligne de base constante et de valeur moyenne nulle.

Selon un premier mode de réalisation de l'invention, il est possible de déterminer la différence entre les deux fréquences propres de résonance $f_1$ et $f_2$, en découpant le domaine fréquentiel en deux sous-bandes : une première sous-bande de fréquences contenant au moins la fréquence propre de résonance $f_1$ du premier résonateur, et une seconde sous-bande de fréquences contenant au moins la fréquence propre de résonance $f_2$ du second résonateur. Les deux sous-bandes peuvent être choisies de sorte que les caractéristiques du niveau du signal mélangé et filtré soient similaires dans les deux sous-bandes. La similarité est d'autant plus forte que les deux résonateurs formant le capteur différentiel présentent des facteurs de qualité proches, ce qui est généralement recherché par conception d'un capteur différentiel.

Un estimateur de la similarité entre les caractéristiques du niveau du signal mélangé et filtré dans les deux sous-bandes peut être formé par le coefficient d'inter-corrélation défini par la relation suivante :

$$X_{corr}(t) = \sum_{k=-M}^{M} s_1(k) s_2(k-t) \qquad (3) \ ;$$

où M désigne un nombre de points de fréquences d'interrogation f dans une sous-bande de fréquences, la seconde sous-bande de fréquences supposée contenir au moins la seconde fréquence de résonance comprenant N-M points (les deux sous-bandes de fréquences étant balayées par le même pas de fréquence $\Delta f$). Lors du calcul d'intercorrélation, la sous-bande la plus petite est complétée par des zéros en dehors de la bande de mesure, selon un principe communément désigné par le terme anglais "zero-padding", $s_1$ et $s_2$ désignent respectivement le niveau du signal mélangé et filtré pour la première et la seconde sous-bande de fréquences. La variable t, classiquement nommée retard, représentant l'intervalle dont il faut décaler le signal $s_1$ pour que celui-ci ressemble au mieux au signal $s_2$, n'est en réalité qu'un indice de décalage de $s_1$ par rapport à $s_2$. Pour la suite de la présente description, les signaux $s_1$ et $s_2$ sont des réponses spectrales (coefficient de réflexion en fonction de la fréquence) ; dans un souci de clarté, bien qu'en abscisses figurent des valeurs de fréquences, et qu'en réalité la valeur à déterminer soit un écart de fréquence entre $f_1$ et $f_2$ par l'exploitation de la relation (3) précitée, la nomenclature consistant à nommer t un « retard » sera conservée.

Le coefficient d'inter-corrélation $X_{corr}$ tel que défini dans la relation (3) ci-dessus présente une valeur maximale positionnée pour un retard t correspondant à la translation du signal $s_2$ de sorte que celui-ci présente un maximum de ressemblance avec le signal $s_1$. Le niveau du maximum d'inter-corrélation peut être exploité pour valider la qualité de la mesure : en-deçà d'un seuil prédéfini, la mesure peut être considérée comme invalide, et la position du maximum d'inter-corrélation fournit l'information de différence de fréquences recherchée.

Afin de s'affranchir d'artéfacts du calcul de l'estimateur d'inter-corrélation (biais associé à une valeur moyenne non-nulle), les moyens adéquats précités permettant de ramener la ligne de base des deux courbes 20, 22 à une valeur constante, peuvent par exemple consister en un retranchement d'un ajustement polynomial en une pluralité de points, pour chacun des deux signaux indépendamment.

Le coefficient d'inter-corrélation permet de déterminer la distance entre les deux signaux représentatifs des résonances : seule la présence de résonances peut fournir une corrélation non-nulle. En pratique, il est par exemple possible de réaliser le produit de corrélation des signaux si et $s_2$ et d'en extraire la valeur maximale, afin de permettre la détermination de la différence entre les deux fréquences propres de résonance $f_1$ et $f_2$.

Ainsi que cela est décrit précédemment, la caractéristique de niveau du signal reçu en écho peut être formée par la caractéristique de l'amplitude de la composante en phase I du signal reçu, ou bien par la caractéristique de l'amplitude de la composante de quadrature Q de ce signal.

Dans un mode de réalisation, la caractéristique de niveau du signal reçu en écho peut être formée par le nombre complexe formé par les composantes en phase et de quadrature, soit $I + jQ$ où $j^2 = -1$. L'exploitation de cette caractéristique présente l'avantage d'une meilleure stabilité du résultat de la mesure par rapport à l'environnement du capteur. La différence entre les deux fréquences propres de résonance $f_1$ et $f_2$ peut ainsi être déterminée à partir de la valeur maximale du module de la fonction d'inter-corrélation $\max(|xcorr(I + jQ)|)$.

Avantageusement, dans le mode de réalisation décrit ci-dessus, il est possible de s'affranchir d'un biais résiduel avec l'environnement électromagnétique de l'interrogateur, en apportant une correction de la différence de fréquences ainsi obtenue. La correction peut être réalisée au moyen d'une fonction affine de la phase de la fonction d'inter-corrélation $\varphi(|xcorr(I + jQ)|)$ prise à la position du maximum du module de la fonction d'inter-corrélation, la phase de l'inter-corrélation complexe présentant une fonction bijective avec le biais résiduel précité. Une telle correction peut faire l'objet d'une étape additionnelle dans un procédé selon l'un des modes de réalisation décrits.

Connaissant les bornes de fréquences des deux sous-bandes de fréquences désignées respectivement par les intervalles [$f_{1min}$ ; $f_{1max}$] et [$f_{2min}$ ; $f_{2max}$] contenant les signaux $s_1$ et $s_2$ respectivement, en supposant que la bande

de fréquences totale N×Δf est balayée en N points par pas de Δf, par une mesure de deux sous-bandes d'indices de 0 à M et M à N (N-M étant éventuellement différent de M, M étant en pratique par exemple supérieur ou égal à N-M), alors ayant identifié le retard (c'est-à-dire un écart de fréquences, ainsi que décrit précédemment) t qui maximise l'inter-corrélation des signaux $s_1$ et $s_2$, l'écart de fréquence entre les fréquences de résonance des deux transducteurs peut se formuler suivant la relation suivante :

$$f_2 - f_1 = (t + M).\Delta f + (f_{2\,\min} - f_{1\,\max}) \qquad (4).$$

La relation (4) ci-dessus est la loi générale lorsque les deux sous-bandes de fréquences [$f_{1min}$ ;$f_{1max}$] et [$f_{2min}$;$f_{2max}$] ne sont pas contiguës. En pratique, il peut être préférable de choisir les bornes des deux sous-bandes de fréquences de manière à ce que la fréquence maximale $f_{1max}$ de la première bande de fréquences soit égale à la fréquence minimale $f_{2min}$ de la seconde sous-bande de fréquences : ainsi, la loi formulée dans la relation (4) peut s'écrire plus simplement suivant la relation suivante :

$$f_2 - f_1 = (t + M).\Delta f \qquad (5).$$

Il est rappelé ici que le retard t est compris dans la gamme [-M ;+M], l'écart de fréquence entre les fréquences de résonance est bien ainsi supérieur ou égal à 0.

Avantageusement, il est possible de procéder à un ajustement, par exemple à un ajustement polynomial, tel qu'un ajustement parabolique, du produit de corrélation des signaux $s_1$ et $s_2$, afin d'améliorer la résolution de la mesure. Cet ajustement vise à remédier au problème de niveau de base variable, associé à une isolation insuffisante entre émission et réception. Il est également possible de remédier à ce problème en optimisant l'isolation entre émission et réception, par exemple en recourant à une configuration bistatique ou bien un utilisant un commutateur radiofréquence entre les voies d'émission et de réception de l'interrogateur. Cet ajustement parabolique est effectué au voisinage du maximum de pic d'inter-corrélation, déterminé en première instance par une recherche de maximum une fois la bande ISM entièrement balayée, suivant une méthode en elle-même connue et décrite dans la demande de brevet internationale publiée sous la référence WO/2009/103769.

Dans un mode de réalisation alternatif de la présente invention, il est possible de déterminer l'auto-corrélation du niveau du signal mélangé et filtré sur l'intégralité de la bande de fréquences, c'est-à-dire comprenant les deux sous-bandes précitées. L'auto-corrélation présente un maximum pour un retard nul, ainsi que deux maxima secondaires de part et d'autre de ce maximum. La distance entre ces deux maxima secondaires permet alors de déterminer directement le double de l'écart de fréquence entre les deux fréquences propres de résonance $f_1$ et $f_2$, ou bien l'écart de fréquence entre le maximum de la courbe d'auto-corrélation (retard nul) et chaque maximum secondaire, offrant ainsi une mesure redondante mais sécurisée. Ce mode de réalisation requiert plus de ressources de calcul que le mode précédemment décrit basé sur une inter-corrélation dans deux sous-bandes de fréquences, cependant il présente l'intérêt de ne pas nécessiter un découpage de la mesure en deux sous-bandes distinctes et permet de fait une exploitation complète de la bande ISM, les fréquences de résonance pouvant ainsi évoluer dans des bornes fixées a priori.

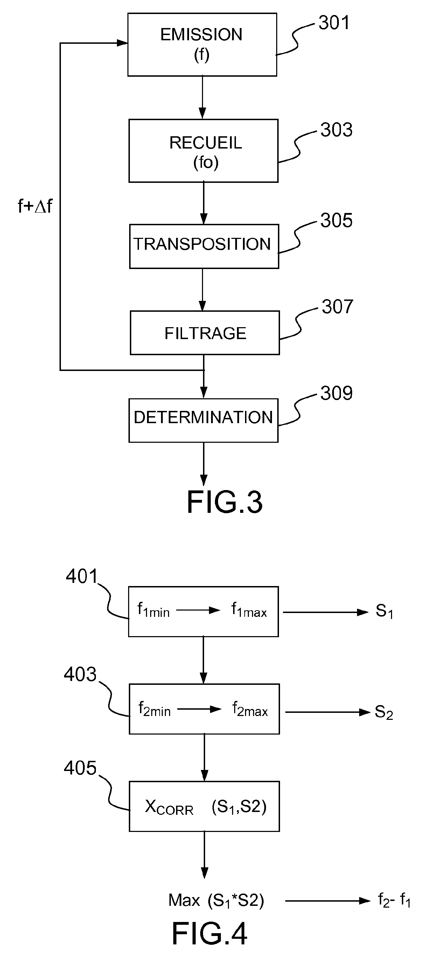

La figure 3 présente un logigramme illustrant un procédé d'interrogation d'un capteur SAW ou BAW différentiel, selon un mode de réalisation de l'invention. Les étapes décrites à titre d'exemple dans la figure 3, mettent essentiellement en oeuvre les principes évoqués précédemment.

Un procédé d'interrogation peut comprendre une étape d'émission 301 d'un signal électromagnétique radiofréquence d'une fréquence f variable. En première itération, la fréquence peut avoir une valeur minimale $f_{min}$. L'étape d'émission 301 peut être suivie d'une étape de recueil 303 du signal reçu en écho du capteur différentiel.

Une étape de transposition 305 peut alors permettre la mise en oeuvre du mélange du signal reçu en écho avec un signal radiofréquence dont la fréquence égale la fréquence f du signal électromagnétique émis.

Une étape de filtrage 307 peut alors permettre d'éliminer les fréquences hautes du signal mélangé lors de l'étape de transposition 305.

La fréquence d'interrogation f peut alors être variée, par exemple d'un pas de fréquence Δf, et le procédé peut reprendre à l'étape d'émission 301, jusqu'à l'étape de filtrage 307, jusqu'à ce que la fréquence d'interrogation f ait été variée dans tout le domaine, couvrant au moins les gammes de fréquences comprenant les valeurs possibles des deux fréquences propres de résonance $f_1$ et $f_2$.

D'un point de vue pratique, pour la mise en oeuvre du premier mode de réalisation précité, le découpage en deux sous-bandes de fréquences peut être préalable, et la fréquence d'interrogation f peut être variée dans une première sous-bande de fréquences s'étalant au moins de la première fréquence minimale $f_{1min}$ à la première fréquence maximale $f_{1max}$, puis dans une seconde sous-bande de fréquences s'étalant au moins de la seconde fréquence minimale $f_{2min}$ à

la seconde fréquence maximale $f_{2max}$. La fréquence d'interrogation f peut également être variée dans toute la bande de fréquences couvrant au moins le domaine de fréquences compris entre la première fréquence minimale $f_{1min}$ et la seconde fréquence maximale $f_{2max}$, le découpage en sous-bande pouvant être réalisé a posteriori.

Dès lors que la fréquence d'interrogation f a été variée dans tout le domaine fréquentiel d'intérêt, une étape de détermination 309 peut permettre la détermination de la différence entre les fréquences propres de résonance $f_1$ et $f_2$, par une analyse de la caractéristique du niveau du signal mélangé et filtré, en fonction de la fréquence d'interrogation f, ainsi que cela est décrit précédemment. Les moyens d'analyse peuvent par exemple réaliser le produit de corrélation des signaux $s_1(f)$ et $s_2(f)$ dans le cadre du premier mode de réalisation décrit précédemment, ou bien l'auto-corrélation du signal unique s(f) dans le cadre du second mode de réalisation décrit, puis en extraire la valeur maximale.

La figure 4 présente un logigramme illustrant un procédé d'interrogation d'un capteur SAW ou BAW différentiel, selon un exemple de réalisation de l'invention.

L'exemple illustré par la figure 4 se relate à un procédé d'interrogation selon le premier mode de réalisation décrit précédemment, dans lequel la fréquence est variée dans deux sous-bandes de fréquences distinctes.

Une première étape de recueil 401 peut permettre l'extraction d'un premier signal $s_1(f)$, par une variation de la fréquence d'interrogation f entre la première fréquence minimale $f_{1min}$ et la première fréquence maximale $f_{1max}$, par une réalisation des étapes 301 à 307 précitées et décrites en référence à la figure 3.

Une seconde étape de recueil 403 peut permettre l'extraction d'un second signal $s_2(f)$, par une variation de la fréquence d'interrogation f entre la seconde fréquence minimale $f_{2min}$ et la seconde fréquence maximale $f_{2max}$, également par une réalisation des étapes 301 à 307 précitées et décrites en référence à la figure 3.

Il est à noter que l'exemple illustré par la figure 4 se rapporte à un procédé d'interrogation selon le premier mode de réalisation précité, dans lequel la fréquence variable est variée dans deux sous-bandes de fréquences distinctes. Dans le cas du second mode de réalisation décrit précédemment, la fréquence peut n'être variée que dans une unique bande de fréquences, auquel cas un unique signal s(f) peut être extrait lors d'une unique étape de recueil, non représentée sur la figure.

La seconde étape de recueil 403 peut alors être suivie d'une étape de calcul 405 du produit de corrélation des signaux $s_1(f)$ et $s_2(f)$. Il est à noter qu'à l'étape de calcul 405, peut d'une manière similaire être calculée l'auto-corrélation de l'unique signal s(f), dans le cas du second mode de réalisation décrit précédemment.

A l'issue de l'étape de calcul 405, il est possible de déterminer, par des moyens de calcul appropriés, la valeur maximale du produit de corrélation ou de l'auto-corrélation, et d'en déduire directement la valeur de la différence entre les fréquences propres $f_1$ et $f_2$ des deux résonateurs, et partant la valeur quantifiée du paramètre physique mesuré.

Ainsi que cela est décrit précédemment, des étapes intermédiaires peuvent être ajoutées aux logigrammes présentés dans les figures 3 et 4. Par exemple, une étape d'ajustement peut être réalisée, en aval des étapes de recueil 401, 403 en référence à la figure 4, permettant la soustraction d'un ajustement parabolique aux signaux $s_1$ et $s_2$, sur la base d'une pluralité de points déterminés.

Avantageusement encore, une étape additionnelle d'ajustement peut être réalisée à l'issue de la détermination du produit de corrélation réalisée lors de l'étape de calcul 405, en référence à la figure 4, permettant l'ajustement de l'inter-corrélation entre les signaux $s_1(f)$ et $s_2(f)$, ou de l'auto-convolution du signal s(f).

Avantageusement encore, il est possible, dans le cadre du premier mode de réalisation précité, à l'issue de la détermination de la différence entre les fréquences propres de résonance $f_1$ et $f_2$, d'ajuster la borne de fréquence de la seconde borne de fréquences balayée sur la base de laquelle est réalisé le balayage de la fréquence d'interrogation f, de manière à ce que la relation suivante soit vérifiée :

$$f_{2\min} + N_T \times \Delta f = f_2 - f_1 + f_{1\min} \qquad (6) ;$$

où $N_T$ désigne le nombre total de points de fréquence d'interrogation dans une sous-bande de fréquences.

Il est ainsi possible de déterminer la valeur de la seconde fréquence minimale $f_{2min}$.

La figure 5 présente un schéma illustrant de manière synoptique, un dispositif d'interrogation d'un capteur SAW ou BAW différentiel, dans un exemple de réalisation de l'invention.

Un dispositif d'interrogation 50 peut comprendre un commutateur radiofréquence 501, contrôlant l'émission des impulsions radiofréquence, via un générateur de signaux radiofréquence 503, et une antenne non représentée sur la figure. Le générateur de signaux radiofréquence 503 permet l'émission des signaux impulsionnels d'interrogation à la fréquence variable f.

Dans l'exemple illustré par la figure 5, un unique résonateur R est représenté. Celui-ci, en écho du signal radiofréquence d'interrogation reçu, réémet à son tour un signal d'écho, essentiellement à sa fréquence propre de résonance $f_0$. Le signal d'écho peut être reçu par une antenne, non représentée sur la figure, et amplifié par un module d'amplification également non représenté sur la figure. Un mélangeur 505 peut permettre le mélange du signal d'écho et de la fréquence variable f, ainsi que cela est décrit précédemment. Un filtre passe-bas 507 peut être relié à une sortie du mélangeur 505. Le niveau s(f) du signal ainsi mélangé et filtré peut alors être stocké par des moyens appropriés. Des moyens de calcul et d'analyse peuvent alors permettre la détermination de la fonction de corrélation, et le calcul de la valeur de différence entre les fréquences propres de résonances et de la valeur quantifiée correspondant au paramètre physique mesuré.

Ainsi que cela est décrit précédemment, le niveau de la composante en phase ou de quadrature du signal filtré et mélangé peut être exploité pour la détermination de la mesure. Ainsi, selon un avantage de la présente invention, il est possible d'utiliser un radio-modem pour réaliser la mesure, et former un dispositif d'interrogation de moindre coût.

Il est par exemple possible d'utiliser un radio-modem à conversion directe, traitant des signaux radiofréquences dans la bande ISM considérée et générant des signaux en phase et de quadrature. Un tel radio-modem peut générer un signal radiofréquence à une fréquence programmée numériquement pour configurer une boucle à verrouillage de phase ou "PLL" fractionnaire, multipliant le signal issu d'un oscillateur de référence en un signal autour de la fréquence de 434±1 MHz issu d'un oscillateur contrôlé en tension ou "VCO", le sigle correspondant à la terminologie anglaise "Voltage-Controlled Oscillator". Le même VCO peut commander l'entrée de l'oscillateur local d'un mélangeur qui ramène la fréquence reçue et amplifiée dans la bande passante d'un filtre passe-bas configurable.

Ainsi, un même radio-modem peut être utilisé à la fois pour l'émission du signal d'interrogation, le recueil du signal d'écho, son amplification, le mélange de fréquences et l'extraction des composantes I et Q permettant l'analyse.

La figure 6 présente un schéma illustrant de manière synoptique, un dispositif d'interrogation d'un capteur SAW ou BAW différentiel, formé par un radio-modem.

A l'instar du dispositif d'interrogation illustré par la figure 5 précédemment décrite, un dispositif d'interrogation 60 peut comprendre un commutateur radiofréquence 601 et un module de génération de signaux radiofréquence 603 fondé sur un VCO recevant une tension de commande $V_{VCO}$. Le signal reçu en écho depuis un résonateur R, reçu par une antenne et après amplification, peut alors être décomposé en composantes en phase et de quadrature, par un démodulateur 600. Le niveau des signaux I ou Q peut alors être exploité par des moyens appropriés non représentés sur la figure.

Le commutateur radiofréquence 601, le module de génération de signaux radiofréquence 603 et le démodulateur 600 peuvent tous être intégrés au radio-modem.

## Revendications

1.  Procédé d'interrogation d'un capteur comportant aux moins deux résonateurs dont la fréquence propre de résonance ($f_1, f_2$) est dépendante d'un paramètre physique, le procédé comprenant:

    - une étape d'émission (301) d'un signal électromagnétique dont la fréquence (f) est variée dans une bande de fréquences par pas de valeur déterminée ($\Delta$f), d'une valeur minimale prédéterminée à une valeur maximale prédéterminée, la bande de fréquences étant découpée en deux sous-bandes de fréquences, chaque sous-bande de fréquence contenant au moins les valeurs attendues respectivement de chaque fréquence propre de résonance ($f_1, f_2$) des deux résonateurs,
    - une étape de recueil (303) d'un signal reçu en écho après une durée déterminée après l'émission réalisée à l'étape d'émission (301), pour chaque fréquence (f) du signal électromagnétique émis, **caractérisé en ce qu'**il comprend également:
    - une étape de transposition (305) du signal reçu en écho en basse fréquence par mélange avec un signal radiofréquence dont la fréquence égale la fréquence (f) du signal électromagnétique émis,
    - une étape de filtrage (307) permettant d'éliminer les fréquences hautes du signal mélangé à l'étape de transposition (305),
    - une étape de détermination (309) de la différence entre les fréquences propres de résonance ($f_1, f_2$) respectives desdits deux résonateurs, à partir du maximum d'inter-corrélation des caractéristiques de niveau du signal ($s_1, s_2$) reçu en écho pour chaque sous-bande de fréquences en fonction de la fréquence du signal électromagnétique émis.

2.  Procédé d'interrogation selon la revendication 1, **caractérisé en ce que** le maximum d'inter-corrélation est défini par la valeur maximale du coefficient d'inter-corrélation défini suivant la relation :

$$X_{corr}(t) = \sum_{k=-M}^{M} s_1(k) s_2(k-t),$$ dans laquelle t désigne un écart de fréquence, $s_1$ désigne le niveau du signal reçu dans la première sous-bande de fréquences, et $s_2$ désigne le niveau du signal reçu dans la seconde bande de fréquences, M désignant un nombre de points de fréquences d'interrogation dans une sous-bande de fréquences, la seconde sous-bande de fréquences supposée contenir au moins la seconde fréquence de résonance comprenant N-M points, N étant le nombre total de points de fréquences d'interrogation.

3. Procédé d'interrogation selon la revendication 2, **caractérisé en ce que** la sous-bande la plus étroite est complétée par des zéros pour les points de fréquences d'interrogation situés en dehors de la bande de mesure, de manière à ce que le nombre de points de fréquences soit identique pour les deux sous-bandes de fréquences.

4. Procédé d'interrogation selon la revendication 3, **caractérisé en ce que** ladite différence entre les fréquences propres de résonances est déterminée suivant la relation : $f_2 - f_1 = (t + M).\Delta f$, t désignant l'écart de fréquence pour lequel le coefficient d'inter-corrélation est maximal.

5. Procédé d'interrogation d'un capteur comportant aux moins deux résonateurs dont la fréquence propre de résonance ($f_1$, $f_2$) est dépendante d'un paramètre physique, le procédé étant **caractérisé en ce qu'**il comprend :

   - une étape d'émission (301) d'un signal électromagnétique dont la fréquence (f) est variée dans une bande de fréquences par pas de valeur déterminée ($\Delta f$), d'une valeur minimale prédéterminée à une valeur maximale prédéterminée,
   - une étape de recueil (303) d'un signal reçu en écho après une durée déterminée après l'émission réalisée à l'étape d'émission (301), pour chaque fréquence (f) du signal électromagnétique émis,
   - une étape de transposition (305) du signal reçu en écho en basse fréquence par mélange avec un signal radiofréquence dont la fréquence égale la fréquence (f) du signal électromagnétique émis,
   - une étape de filtrage (307) permettant d'éliminer les fréquences hautes du signal mélangé à l'étape de transposition (305),
   - une étape de détermination (309) de la différence entre les fréquences propres de résonance ($f_1$, $f_2$) respectives desdits deux résonateurs, à partir du maximum d'auto-corrélation de la caractéristique de niveau du signal (s) reçu en écho.

6. Procédé d'interrogation selon l'une quelconque des revendications précédentes, **caractérisé en ce que** la caractéristique de niveau du signal reçu en écho est formée par la caractéristique de l'amplitude de la composante en phase (I) dudit signal reçu.

7. Procédé d'interrogation selon l'une quelconque des revendications précédentes, **caractérisé en ce que** la caractéristique de niveau du signal reçu en écho est formée par la caractéristique de l'amplitude de la composante de quadrature (Q) dudit signal reçu.

8. Procédé d'interrogation selon l'une quelconque des revendications précédentes, **caractérisé en ce que** la caractéristique de niveau du signal reçu en écho est formée par le nombre complexe formé par les composantes en phase et de quadrature dudit signal reçu, soit $I + jQ$, où $j^2 = -1$, la différence entre les fréquences propres de résonance ($f_1$, $f_2$) respectives des deux résonateurs étant déterminée à partir du module du maximum d'inter-corrélation ou d'auto-corrélation.

9. Procédé d'interrogation selon la revendication 8, **caractérisé en ce qu'**il comprend une étape additionnelle de correction de la différence entre les fréquences propres de résonance ($f_1$, $f_2$) réalisée au moyen d'une fonction affine de la phase de la fonction d'inter-corrélation ou d'auto-corrélation prise à la position du maximum du module de la fonction d'inter-corrélation ou d'auto-corrélation.

10. Procédé d'interrogation selon l'une quelconque des revendications précédentes, **caractérisé en ce qu'**il comprend une étape d'ajustement ramenant la ligne de base des caractéristiques de niveau du signal reçu en écho à une valeur constante.

11. Procédé d'interrogation selon la revendication 10, **caractérisé en ce que** ladite valeur constante est nulle.

12. Dispositif d'interrogation (50) adapté à mettre en oeuvre un procédé d'interrogation selon l'une quelconque des revendications précédentes, le dispositif d'interrogation (50) comprenant au moins :

   • un commutateur radiofréquence (501),
   • un générateur de signaux radiofréquence (503) contrôlé par le commutateur radiofréquence et émettant les signaux d'interrogation à ladite fréquence variable (f), une antenne d'émission,
• une antenne de réception recevant les signaux en écho,
• un module d'amplification amplifiant les signaux reçus par l'antenne de réception,
• un mélangeur (505) mélangeant le signal reçu en écho amplifié et un signal périodique à ladite fréquence variable (f),
• un filtre passe-bas (507) relié à une sortie du mélangeur (505),
• des moyens de stockage stockant le niveau (s(f)) du signal mélangé et filtré,
• des moyens de calcul et d'analyse déterminant ledit maximum d'inter-corrélation ou d'auto-corrélation.

13. Dispositif d'interrogation (50) selon la revendication 12, **caractérisé en ce qu'**il est formé par un dispositif de type radio-modem.

**Patentansprüche**

1. Verfahren zum Abfragen eines Sensors, der wenigstens zwei Resonatoren umfasst, deren Resonanz-Eigenfrequenz ($f_1$, $f_2$) von einem physikalischen Parameter abhängt, wobei das Verfahren Folgendes beinhaltet:

   einen Schritt (301) des Sendens eines elektromagnetischen Signals, dessen Frequenz (f) in einem Frequenzband um Stufen von vorbestimmtem Wert ($\Delta f$) zwischen einem vorbestimmten Mindestwert und einem vorbestimmten Höchstwert variiert, wobei das Frequenzband in zwei Frequenzsubbänder unterteilt ist, wobei jedes Frequenzsubband wenigstens die jeweils erwarteten Werte von jeder Resonanz-Eigenfrequenz ($f_1$, $f_2$) der beiden Resonatoren enthält,
   einen Schritt (303) des Sammelns eines empfangenen Echosignals nach einer bestimmten Dauer nach dem im Sendeschritt (301) durchgeführten Senden für jede Frequenz (f) des gesendeten elektromagnetischen Signals, **dadurch gekennzeichnet, dass** es auch die folgenden Schritte beinhaltet:

   einen Schritt (305) des Transponierens des empfangenen Echosignals in eine tiefe Frequenz durch Mischen mit einem Funkfrequenzsignal, dessen Frequenz gleich der Frequenz (f) des gesendeten elektromagnetischen Signals ist,
   einen Schritt (307) des Filterns, mit dem die hohen Frequenzen des im Transpositionsschritt (305) gemischten Signals eliminiert werden,
   einen Schritt des Ermittelns (309) der Differenz zwischen den jeweiligen Resonanz-Eigenfrequenzen ($f_1$, $f_2$) der beiden Resonatoren auf der Basis des Interkorrelationsmaximums von Pegelkennkurven des empfangenen Echosignals ($s_1$, $s_2$) für jedes Frequenzsubband in Abhängigkeit von der Frequenz des gesendeten elektromagnetischen Signals.

2. Abfrageverfahren nach Anspruch 1, **dadurch gekennzeichnet, dass** das Interkorrelationsmaximum durch den maximalen Wert des Interkorrelationskoeffizienten definiert wird, der gemäß der folgenden Relation definiert wird:

   $$X_{corr}(t) = \sum_{k=-M}^{M} s_1(k) s_2(k-t)$$ , wobei t eine Frequenzabweichung bedeutet, $s_1$ den Pegel des empfangenen Signals im ersten Frequenzsubband bedeutet und $s_2$ den Pegel des empfangenen Signals im zweiten Frequenzband bedeutet, wobei M eine Anzahl von Abfragefrequenzpunkten in einem Frequenzsubband bedeutet, wobei das zweite Frequenzsubband wenigstens die zweite Resonanzfrequenz enthalten soll, die N-M Punkte umfasst, wobei N die Gesamtzahl von Abfragefrequenzpunkten ist.

3. Abfrageverfahren nach Anspruch 2, **dadurch gekennzeichnet, dass** das schmalste Subband durch Nullen für die Abfragefrequenzpunkte vervollständigt wird, die sich außerhalb des Messbandes befinden, so dass die Anzahl von Frequenzpunkten für die beiden Frequenzsubbänder identisch ist.

4. Abfrageverfahren nach Anspruch 3, **dadurch gekennzeichnet, dass** die Differenz zwischen den Resonanz-Eigenfrequenzen gemäß der folgenden Relation bestimmt wird: $f_2 - f_1 = (t + M).\Delta f,$ wobei t die Frequenzabweichung bedeutet, für die der Interkorrelationskoeffizient maximal ist.

5. Verfahren zum Abfragen eines Sensors, der wenigstens zwei Resonatoren umfasst, deren Resonanz-Eigenfrequenz ($f_1$, $f_2$) von einem physikalischen Parameter abhängig ist, wobei das Verfahren **dadurch gekennzeichnet ist, dass** es Folgendes beinhaltet:

einen Schritt (301) des Sendens eines elektromagnetischen Signals, dessen Frequenz (f) in einem Frequenzband um Stufen von vorbestimmtem Wert (Δf) zwischen einem vorbestimmten Mindestwert und einem vorbestimmten Höchstwert variiert,

einen Schritt (303) des Sammelns eines empfangenen Echosignals nach einer bestimmten Dauer nach dem im Sendeschritt (301) durchgeführten Senden für jede Frequenz (f) des gesendeten elektromagnetischen Signals,

einen Schritt (305) des Transponierens des empfangenen Echosignals in eine tiefe Frequenz durch Mischen mit einem Funkfrequenzsignal, dessen Frequenz gleich der Frequenz (f) des gesendeten elektromagnetischen Signals ist,

einen Schritt (307) des Filterns, mit dem die hohen Frequenzen des im Transpositionsschritt (305) gemischten Signals eliminiert werden,

einen Schritt des Ermittelns (309) der Differenz zwischen den jeweiligen Resonanz-Eigenfrequenzen ($f_1$, $f_2$) der beiden Resonatoren auf der Basis des Interkorrelationsmaximums von Pegelkennkurven des empfangenen Echosignals (s).

6. Abfrageverfahren nach einem der vorherigen Ansprüche, **dadurch gekennzeichnet, dass** die Pegelkennkurve des empfangenen Echosignals durch die Kennkurve der Amplitude der Phasenkomponente (I) des empfangenen Signals gebildet wird.

7. Abfrageverfahren nach einem der vorherigen Ansprüche, **dadurch gekennzeichnet, dass** die Pegelkennkurve des empfangenen Echosignals durch die Kennkurve der Amplitude der Quadratur-Komponente (Q) des empfangenen Signals gebildet wird.

8. Abfrageverfahren nach einem der vorherigen Ansprüche, **dadurch gekennzeichnet, dass** die Pegelkennkurve des empfangenen Echosignals durch die komplexe Zahl gebildet wird, die durch die Phasen- und Quadratur-Komponenten des empfangenen Signals gebildet wird, nämlich $I + jQ$, wobei $j^2 = -1$, wobei die Differenz zwischen den jeweiligen Resonanz-Eigenfrequenzen ($f_1$, $f_2$) der beiden Resonatoren auf der Basis des Moduls des Interkorrelations- oder Autokorrelationsmaximums bestimmt wird.

9. Abfrageverfahren nach Anspruch 8, **dadurch gekennzeichnet, dass** es einen zusätzlichen Schritt des Korrigierens der Differenz zwischen den Resonanz-Eigenfrequenzen ($f_1$, $f_2$) beinhaltet, realisiert mittels einer affinen Funktion der Phase der Interkorrelations- oder Autokorrelationsphase, genommen an der Position des Maximums des Moduls der Interkorrelations- oder Autokorrelationsfunktion.

10. Abfrageverfahren nach einem der vorherigen Ansprüche, **dadurch gekennzeichnet, dass** es einen Justageschritt beinhaltet, in dem die Basislinie der Pegelkennkurven des empfangenen Echosignals auf einen konstanten Wert gebracht wird.

11. Abfrageverfahren nach Anspruch 10, **dadurch gekennzeichnet, dass** der konstante Wert null ist.

12. Abfragevorrichtung (50), ausgelegt zum Ausführen eines Abfrageverfahrens nach einem der vorherigen Ansprüche, wobei die Abfragevoruchtung (50) wenigstens Folgendes umfasst:

einen Funkfrequenzschalter (501),

einen Funkfrequenzsignalgenerator (503), der durch den Funkfrequenzschalter gesteuert ist, und die Abfragesignale auf der variablen Frequenz (f) sendet,

eine Sendeantenne,

eine Empfangsantenne, die die Echosignale empfängt,

ein Verstärkungsmodul, das die von der Empfangsantenne empfangenen Signale verstärkt,

einen Mischer (505), der das verstärkte empfangene Echosignal und ein periodisches Signal auf der variablen Frequenz (f) mischt,

ein Tiefpassfilter (507), das mit einem Ausgang des Mischers (505) verbunden ist,

Speichermittel zum Speichern des Pegels (s(f)) des gemischten und gefilterten Signals,

Rechen- und Analysemittel, die das Interkorrelations- oder Autokorrelationsmaximum bestimmen.

**13.** Abfragevorrichtung (50) nach Anspruch 12, **dadurch gekennzeichnet, dass** sie durch eine Vorrichtung des Funkmodemtyps gebildet wird.

**Claims**

**1.** A method of interrogating a sensor comprising at least two resonators whose natural resonant frequency ($f_1$, $f_2$) is dependent on a physical parameter, the method comprising:

a step of emitting (301) an electromagnetic signal whose frequency (f) is varied in a frequency band by increments of determined value (f), from a predetermined minimum value to a predetermined maximum value, the frequency band being split into two frequency sub-bands, each frequency sub-band containing at least the expected values respectively of each natural resonant frequency ($f_1$, $f_2$) of the two resonators,
a step of gathering (303) a signal received as an echo after a determined duration after the emission carried out in the emission step (301), for each frequency (f) of the electromagnetic signal emitted, **characterised in that** it also comprises:

a step of transposing (305) the signal received as the echo to low frequency by mixing with a radiofrequency signal whose frequency equals the frequency (f) of the electromagnetic signal emitted,
a filtering step (307) to eliminate the high frequencies of the signal mixed in the transposition step (305),
a step of determining (309) the difference between the respective natural resonant frequencies ($f_1$, $f_2$) of the said two resonators, on the basis of the cross-correlation maximum of the characteristics of the level of the signal ($s_1$, $s_2$) received as the echo for each frequency sub-band as a function of the frequency of the electromagnetic signal emitted.

**2.** The interrogation method according to claim 1, **characterised in that** the cross-correlation maximum is defined by the maximum value of the cross-correlation coefficient defined according to the relation:

$$X_{corr}(t) = \sum_{k=-M}^{M} s_1(k) s_2(k-t),$$ in which t denotes a frequency gap, $s_1$ denotes the level of the signal received in the first frequency sub-band, and $s_2$ denotes the level of the signal received in the second frequency band, M denoting a number of interrogation frequency points in a frequency sub-band, the second frequency sub-band assumed to contain at least the second resonant frequency comprising N-M points, N being the total number of interrogation frequency points.

**3.** The interrogation method according to claim 2, **characterised in that** the narrowest sub-band is supplemented with zeros for the interrogation frequency points situated outside of the measurement band, in such a way that the number of frequency points is identical for the two frequency sub-bands.

**4.** The interrogation method according to claim 3, **characterised in that** the said difference between the natural resonant frequencies is determined according to the relation: $f_2 - f_1 = (t + M).\Delta f$, t denoting the frequency gap for which the cross-correlation coefficient is maximal.

**5.** A method of interrogating a sensor comprising at least two resonators whose natural resonant frequency ($f_1$, $f_2$) is dependent on a physical parameter, the method comprising:

a step of emitting (301) an electromagnetic signal whose frequency (f) is varied in a frequency band by increments of determined value (f), from a predetermined minimum value to a predetermined maximum value,
a step of gathering (303) a signal received as an echo after a determined duration after the emission carried out in the emission step (301), for each frequency (f) of the electromagnetic signal emitted,
a step of transposing (305) the signal received as the echo to low frequency by mixing with a radiofrequency signal whose frequency equals the frequency (f) of the electromagnetic signal emitted,
a filtering step (307) to eliminate the high frequencies of the signal mixed in the transposition step (305),
a step of determining (309) the difference between the respective natural resonant frequencies ($f_1$, $f_2$) of the said two resonators, on the basis of the auto-correlation maximum of the characteristic of the level of the signal (s) received as the echo.

6. The interrogation method according to any one of the preceding claims, **characterised in that** the characteristic of the level of the signal received as the echo is formed by the characteristic of the amplitude of the in-phase component (I) of the said signal received.

7. The interrogation method according to any one of the preceding claims, **characterised in that** the characteristic of the level of the signal received as the echo is formed by the characteristic of the amplitude of the quadrature component (Q) of the said signal received.

8. The interrogation method according to any one of the preceding claims, **characterised in that** the characteristic of the level of the signal received as the echo is formed by the complex number formed by the in-phase and quadrature components of the said signal received, given $I + jQ$, where $j^2 = -1$, the difference between the respective natural resonance frequencies ($f_1$, $f_2$) of the two resonators being determined based upon the modulus of the maximum of the cross-correlation or autocorrelation function.

9. The interrogation method according to claim 8, **characterised in that** it comprises an additional step of correction of the difference between the natural resonance frequencies ($f_1$, $f_2$) realized by means of an affine function of the phase of the cross-correlation or autocorrelation function considered at the position of the maximum of the modulus of the cross-correlation or autocorrelation function.

10. The interrogation method according to any one of the preceding claims, **characterised in that** it comprises an adjustment step bringing the base line of the characteristics of the level of the signal received as the echo to a constant value.

11. The interrogation method according to claim 10, **characterised in that** the constant value is zero.

12. The interrogation device (50) adapted to implement an interrogation method according to any one of the preceding claims, the interrogation device (50) comprising at least:

   a radiofrequency switch (501),
   a radiofrequency signal generator (503) controlled by the radiofrequency switch and emitting the interrogation signals at said variable frequency (f),
   an emission antenna,
   a reception antenna receiving the signals as the echo,
   an amplification module amplifying the signals received by the reception antenna,
   a mixer (505) mixing the amplified signal received as the echo and a periodic signal at said variable frequency (f),
   a low-pass filter (507) linked to an output of the mixer (505),

   storage means storing the level (s(f)) of the mixed and filtered signal,
   calculation and analysis means determining said cross-correlation maximum or auto-correlation maximum.

13. The interrogation device (50) according to claim 12, **characterised in that** it is formed by a device of radio-modem type.

I et Q 30dB uC

FIG.1

EP 2 559 972 B1

FIG.2

EP 2 559 972 B1

FIG.3

FIG.4

FIG.5

FIG.6

EP 2 559 972 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2009103769 A

**Littérature non-brevet citée dans la description**

- **FRIEDT, J.-M. ; DROIT, C. ; MARTIN, G. ; BALLAN-DRAS, S.** A wireless interrogation system exploiting narrowband acoustic resonator for remote physical quantity measurement. *Rev. Sci. Instrum.,* 2010, vol. 81, 014701

- **HAMSCH, M. ; HOFFMANN, R. ; BUFF, W. ; BIN-HACK, M. ; KLETT, S.** An interrogation unit for passive wireless SAW sensors based on Fourier transform Ultrasonics, Ferroelectrics and Frequency Control. *IEEE Transactions,* Novembre 2004